(19) Europäisches Patentamt
European Patent Office
Office européen des brevets

(11) **EP 0 878 892 A2**

(12) **EUROPÄISCHE PATENTANMELDUNG**

(43) Veröffentlichungstag:
18.11.1998 Patentblatt 1998/47

(51) Int. Cl.$^6$: **H02J 13/00**

(21) Anmeldenummer: 98108575.6

(22) Anmeldetag: 12.05.1998

(84) Benannte Vertragsstaaten:
AT BE CH CY DE DK ES FI FR GB GR IE IT LI LU
MC NL PT SE
Benannte Erstreckungsstaaten:
AL LT LV MK RO SI

(30) Priorität: 15.05.1997 DE 19720315

(71) Anmelder: ITF-EDV Fröschl GmbH
93194 Walderbach (DE)

(72) Erfinder:
• Fröschl, Wilfried
  93152 Etterzhausen (DE)
• Zintl, Peter
  93092 Friesheim/Barbing (DE)

(74) Vertreter:
Graf, Helmut, Dipl.-Ing. et al
Postfach 10 08 26
93008 Regensburg (DE)

(54) **Verfahren zur Erfassung und/oder Berechnung von abrechnungsrelevanten Verbrauchsgrössen**

(57) Die Erfindung bezieht sich auf ein neuartiges System sowie Verfahren zur Erfassung und/oder Berechnung von abrechnungsrelevanten Verbrauchsgrößen.

FIG. 1

**Beschreibung**

Die Erfindung bezieht sich auf ein Verfahren gemäß Oberbegriff Patentanspruch 1.

„Leistungsempfänger" in Sinne der Erfindung sind u.a. natürliche und juristische Personen, Firmen, Behörden usw., die die von einem Leistungsanbieter gelieferte Leistung verbrauchen, Weiterverteiler von Energie und/oder Leistungen usw..

„Leistungsverbraucher" sind im Sinne der Erfindung u.a. Geräte, Einrichtungen, Systeme usw., an oder in denen die angebotene Leistung verbraucht und/oder weiterverteilt wird.

„Meßstellen" im Sinne der Erfindung sind u.a. diejenigen Orte, an denen die gelieferte und/oder verbrauchte Leistung durch wenigstens eine Meßstation ermittelt wird.

„Verbrauchsgrößen oder -Werte" im Sinne der Erfindung sind solche Größen, die den Verbrauch an Elektrizität, Gas, Wasser, Wärme usw. betreffen.

Speziell die für Sondervertragskunden verwendeten Elektrizitätszähler umfassen zusätzlich zu dem eigentlichen Meßwerk, welches aus Spannung und Strom unter Berücksichtigung der Phasenlage den Leistungswert (verbrauchte Energie je Zeiteinheit) ermittelt und ein diesem Leistungswert proportionales Signal liefert, eine aufwendige Meßwertverarbeitung (Tarif-Modul), in welchem die von dem Meßwerk gelieferten Meßwerte bewertet und die verbrauchte Energie nach Tarifen (Verbrauch in unterschiedlichen Zeitzonen oder Tarifzeiten) sowie u.a. auch Leistungshöchstwerte innerhalb einer bestimmten Abrechnungsperiode ermittelt werden, und zwar auch unter Berücksichtigung von Steuersignalen, die eine interne, mit einer Echtzeit-Uhr versehene Steuereinheit des Zählers liefert oder die von außen über Steuerleitungen zugeführt werden. Hierbei ist es dann vielfach auch üblich, Leistungshöchstwerte getrennt nach Tarifen zu erfassen. Mit Abschluß einer Abrechnungsperiode muß dann eine Rückstellung der Leistungshöchstwerte auf Null erfolgen, und zwar durch ein entsprechendes Steuersignal. Die jeweiligen Verbrauchsdaten bzw. Zählerstände und Leistungshöchstwerte abgeschlossener Abrechnungsperioden werden im Meßwertspeicher festgehalten. Zusätzlich werden vielfach die Leistungswerte jeder Meß- oder Abrechnungsperiode auch als Lastprofil, d.h. als zeitlich abhängige Leistungswerte von der Meßwertverarbeitung ermittelt und im Meßwertspeicher abgespeichert. Sämtliche verrechnungsrelevanten Daten werden zugleich auch auf einer Anzeige des Zählers dargestellt, und zwar entweder zyklisch oder auf Tastendruck. Diese Anzeigen sind dann beispielsweise elektronisch ausgeführt, können aber auch mechanische Rollenzählwerke sein.

Bekannt ist ein sogenannter Alpha-Zähler (Elektrizitätswirtschaft, Jg. 95(1996), Heft 11, Seiten 701 - 705) zur Erfassung und/oder Berechnung von abrechnungsrelevanten Verbrauchsgrößen, der von Leistungsabnehmern bezogenen elektrischen Energie, wobei dieser Zähler u.a. ein Meßmodul zur Messung und Registrierung des Verbrauchs an elektrischer Energie, ein Tarifmodul, in dem die tarifrelevanten Parameter im Zähler abgelegt sind, ein Kommunikationsmodul sowie einen Mikroprozessor aufweist. Über das Kommunikationsmodul und ein Datennetz steht der Zähler mit einem an das Datennetz angeschlossenen Rechner oder Server einer EVU-Leitzentrale in Verbindung, und zwar für eine bidirektionale Datenübertragung. Über diese Datenübertragung ist dann u.a. auch ein Fernauslesen der im Zähler gespeicherten, abrechnungsrelevanten Verbrauchsgrößen möglich. Diese werden dort unter Berücksichtigung des vom Meßmodul gemessenen Verbrauchs und der im Zähler abgelegten tarifrelevanten Parameter ermittelt. Die bidirektionale Datenübertragung ermöglicht weitere Funktionen, wie z.B. Alarm- und Fehlermeldungen an die EVU-Leitzentrale.

Ein ähnliches Verfahren zur Zählerfernablesung mit Datenfernübertragung zur Kostenentlastung bei der monatlichen Zähler-Ablesung von Sondervertragskunden ist in der Veröffentlichung „Neue Konzepte in der Zählerablesung DFÜ-System im Einsatz bei Versorgungsunternehmen", Elektrizitätswirtschaft, Jahrgang 1995 (1996), Heft 11, Seiten 697 - 700 beschrieben. Auch bei diesem bekannten Konzept ist vorgesehen, die tarifrelevanten Parameter (Tarifmodul) im Zähler abzulegen und die Tarifbehandlung im Zähler vorzunehmen.

Bekannt ist weiterhin ein Zähler zum Messen und Erfassen von elektrischer Energie (DE 195 26 870 C1), bei dem das Meßwerk zur Erhöhung der Redundanz zwei Meßmodule aufweist, die nach unterschiedlichen Meßprinzipien arbeiten, wobei die Meßwerte beider Module in einer Meßelektronik des Zählers angezeigt und gespeichert werden. Dieser bekannte Zähler ist ebenfalls fern ablesbar.

Bekannt ist schließlich eine Anlage zur Fernzählung bei Elektrizitätszählern (DE 36 15 402 A1). Die Anlage umfaßt mehrere Zähler, die einem Coder und einer Zentralstation zugeordnet sind. Der Coder nimmt Roh-Impulse, die festen Elektrizitätsmengen entsprechen, von den Zählern entgegen und wandelt diese Roh-Impulse in Impulse um, die technischen Energieeinheiten oder deren dekadischen Unterteilungen entsprechen. Diese umgewandelten Impulse werden dann zu Zählerständen aufaddiert, welche in einen Speicher eingelesen werden. Die einzelnen Zähler benötigen kein eigenes Zählwerk, da dieses für eine Gruppe von Zählern in dem Coder realisiert ist, der mit dieser Gruppe von Zählern zu eine plombierbaren Einheit bzw. zu einem Coderzähler zusammengefaßt ist, der für die Fernablesung bzw. Fernüberwachung der Zählerstände über eine Datenleitung mit der Zentralstation in Verbindung steht.

Nachteilig ist, daß diese Zähler insbesondere auch durch das notwendige Tarif-Modul und die notwendigen Anzeige- und Bedienungselemente sehr aufwendig sind und gerade auch die Anzeigeelemente einem hohen Verschleiß unterliegen. Nachteilig ist aber insbesondere auch, daß die bekannten Zähler ein relativ starres Tarif-System bedingen, da Tarif-Änderungen vielfach einen aufwendigen Austausch des jeweiligen Zählers zur Folge hat.

Aufgabe der Erfindung ist es, ein Verfahren aufzuzeigen, bei welchem die Zähler einfacher aufgebaut sein können und dabei eine leichte Anpassung an ein geändertes Tarif-System möglich ist. Vorteilhafte Weiterbildungen mit in den Unteransprüchen angegeben. Zur Lösung dieser Aufgabe ist ein Vefahren entsprechend dem Patentanspruch 1 ausgebildet.

Die Besonderheit der Erfindung besteht darin, daß zur Erfassung und/oder Berechnung von verrechnungsrelevanten Verbrauchs- oder Meßgrößen an der jeweiligen Meßstelle beim jeweiligen Kunden oder Leistungsempfänger lediglich eine vereinfachte Meßstation vorgesehen ist, die die reinen Grund-Daten, welche die den Verbrauch definieren bzw. für die Bestimmung des Verbrauchs notwendig sind, beim Kunden oder Leistungsempfänger mißt, daß diese Daten dann über ein Datennetz, welches beispielsweise ein öffentliches oder aber ein privates Netz mit den unterschiedlichsten Übertragungsmedien ist, an einen der jeweiligen Meßstation zugeordneten Server übertragen wird, in welchem dann z.B. in einem jedem Verbraucher zugeordneten virtuellen Tarifmodul aus diesem Grund Daten unter Berücksichtigung der jeweiligen im Tarif vereinbarten Daten (Tarif-Parameter) die verrechnungsrelevanten Werte ermittelt und zusammen mit den übermittelten Grunddaten gespeichert werden.

Diese Grunddaten sind im einfachsten Fall der in einer bestimmten Abfrage- oder Abrechnungsperiode angefallene Verbrauch und beispielsweise zusätzlich oder anstelle hiervon das sogenannte Leistungsprofil, welches den zeitlichen Verlauf des Verbrauchs wiedergibt. Diese Größe ist insbesondere für die in Rechnungstellung des Verbrauchs an elektrischer Energie relevant, da hier dem jeweiligen Kunden nicht nur die tatsächlich verbrauchte Energie (ggf. unter Berücksichtigung der jeweiligen Zeit- oder Tarif-Zonen), sondern auch die Bereitstellung einer bestimmten maximalen Leistung sowie das Nicht-Überschreiten eines im Tarif festgelegten maximalen Verbrauchswertes innerhalb einer festgelegten Prüf- oder Meßperiode, beispielsweise von jeweils 15 Minuten, verrechnet wird.

Verrechnungsrelevante Tarif-Parameter sind u.a.:

- Tarif- oder Zeit-Zonen bzw. deren Beginn und Ende, insbesondere auch Zeiten für Haupt- und Nebentarife;
- Preis für Haupt- und Nebentarife;
- verbrauchsabhängige Staffelung des Preises für die empfangene oder bezogene Leistung;
- maximal zulässiger oder vereinbarter Verbrauchs- oder Leistungsshöchstwert;
- maximal in einer Prüfperiode zulässiger Verbrauch;
- Anfang und Beginn einer jeden Abrechnungsperiode;
- vereinbarter maximaler Verbrauch während einer Prüfperiode,
- Dauer der Prüfperiode,
- Jahreszeit oder von der Jahreszeit abhängiger Tarif;
- Primärenergie-Kosten bzw. von den Primärenergie-Kosten abhängiger Tarif;
- Beginn und Ende der Bereitstellung von Leistung (bei einem von mehreren Leistungsanbietern belieferten Kunden usw.).

Die Verarbeitung der Grunddaten erfolgt für jede Meßstation in einem virtuellen Tarif-Modul auf dem zugeordneten Server. Die entsprechenden, auch bearbeiteten Daten können dort von dem jeweiligen Kunden jederzeit abgerufen werden.

Auch alle übrigen Daten, einschließlich der üblicherweise in dem internen Zähler-Datensatz eines herkömmlichen Zählers zusätzlich enthaltenen Daten, werden in dem virtuellen Tarif-Modul gebildet und abgespeichert, so daß sie dort für Prüf- und Kontrollzwecke abgerufen werden können.

Die Erfindung wird im Folgenden anhand der Figuren an Ausführungsbeispielen unter Bezugnahme auf den Stand der Technik näher erläutert. Es zeigen:

Fig. 1 in schematischer Darstellung eine mögliche Ausführungsform des erfindungsgemäßen Systems zur Erfassung und/oder Berechnung von verrechnungsrelevanten Verbrauchsgrößen, und zwar erläutert am Beispiel eines Systems zur Erfassung und/oder Berechnung der verrechnungsrelevanten Größen beim Verbrauch von elektrischer Energie;

Fig. 2 in einem vereinfachten Block- oder Funktionsdiagramm eine der Meßstationen des Systems der Fig. 1;

Fig. 3 ein Diagramm, welches einen Verbrauch (in KWh) in zeitlicher Abhängigkeit wiedergibt;

Fig. 4 in Einzeldarstellung und als Block einen als Zählregister dienenden Ringspeicher der Meßstation der Fig. 2;

Fig. 5 in einem vereinfachten Block- bzw. Funktionsdiagramm die wesentlichen in einem der Server des Systems, allerdings softwaremäßig installierten Funktionen;

Fig 6 in einem vereinfachten Block- bzw. Funktionsdiagramm eine mögliche Ausführung einer aus dem Stand der

EP 0 878 892 A2

Technik bekannten Meßstation.

Die nachfolgende Beschreibung bezieht sich auf ein System, mit dem die verrechnungsrelevanten Verbrauchsdaten einer Vielzahl von Abnehmer von elektrischer Energie erfaßt und/oder berechnet werden, so daß dann die von einem EVU gelieferte Energiemenge und auch Leistungsbereitstellung dem jeweiligen Kunden bzw. Leistungsempfänger in Rechnung gestellt werden können, und zwar unter Berücksichtigung der Parameter bzw. Vereinbarungen des mit dem Kunden bestehenden Tarifvertrages. Es versteht sich, daß das nachstehend beschriebene System aber auch für andere Energiearten, beispielsweise für Gas, Wärmeenergie, oder für andere Verbrauchsarten, beispielsweise für Wasser oder die Abnahme von Abwasser angewandt werden kann.

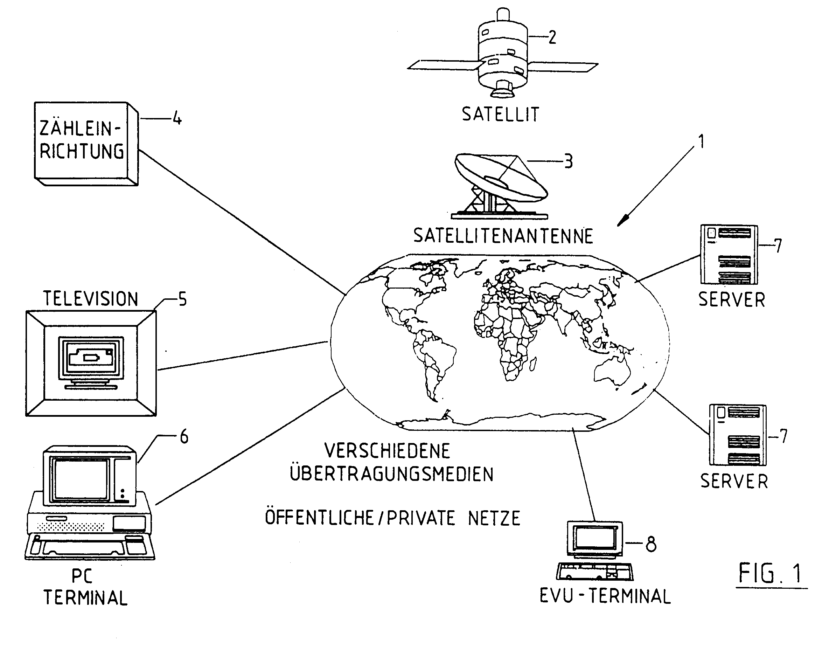

Wie in der Fig. 1 dargestellt ist, umfaßt das System zunächst ein Datenübertragungsnetz 1, welches beispielsweise ein öffentliches Netz oder ein privates Netz ist und welches z.B. weltweit installiert ist, u.a. unter Verwendung von nicht dargestellten Datenübertragungsleitungen, einschließlich Richtfunkstrecken, von Nachrichtensatelliten 2 und entsprechenden Empfangsantennen 3 usw.

Zu dem Datennetz 1, welches beispielsweise auch ein kommerzielles Datennetz oder aber ein privates, d.h. z.B. EVU-eigenes Datennetz sein oder aber auch aus mehreren, miteinander verknüpften Netzen bestehen kann, haben entsprechend der Fig. 1 verschiedene Geräte bzw. Einrichtungen Zugang, und zwar über nicht dargestellte Terminals oder Hosts, nämlich:

- Meßstationen 4,
- TV-Geräte 5,
- PC-Terminals 6,
- Server 7 und
- EVU-Terminal 8.

Tatsächlich sind dem Netz 1 eine Vielzahl von Meßstationen 4 zugeordnet, und zwar wenigstens eine Meßstation 4 für jeden Kunden oder Verbraucher an dessen Meßstelle(n). Weiterhin besitzt jeder Kunde wenigstens ein TV-Gerät oder einen PC-Terminal. Für die von einem EVU betreuten Kunden genügt theoretisch ein einziger Server 7. Allerdings kann es bei einer Vielzahl von Kunden notwendig, zumindest jedoch zweckmäßig sein, für eine reibungslose und schnelle Datenübertragung und Verarbeitung mehrere Server 7 vorzusehen. Weiterhin können aus mehreren Gründen auch mehrere EVU-Terminals vorgesehen werden. Die Meßstationen 4 befinden sich jeweils an den Meßstellen, d.h. z.B. an dem Einspeiseort. Die Server 7 können in beliebiger Entfernung von dem Leistungsempfänger installiert sein.

Eine Besonderheit des in den Figuren 1 - 5 wiedergegebenen Systems besteht darin, daß insbesondere auch bei Sondervertragskunden, die u.U. sehr komplexe, eine Vielzahl von Tarif-Parametern haben, aus denen letztlich unter Berücksichtigung des tatsächlichen Verbrauchs die Rechnungsstellung erfolgt, die Meßstationen 4 jeweils nur den tatsächlichen Verbrauch sowie ein zeitabhängiges Verbrauchs- oder Lastprofil ermittelt, und daß lediglich diese Meßdaten in Form eines digitalen Datensatzes 9 zusammen mit einer Identfikation 10 über das Netzwerk 1 an einen Server 7 übertragen werden, und zwar jeweils am Ende einer vorgegebenen Abfrage- bzw. Abrechnungsperiode, z.B. jeweils am Monatsende, und/oder aufgrund einer entsprechenden Anforderung über das Netzwerk 1 an die jeweilige Meßstation 4. Diese Anforderung erfolgt beispielsweise von dem zugeordneten Server 7 oder aber von einem EVU-Terminal 8. Die Identifikation 10 dient zur Unterscheidung der jeweiligen Meßstation 4 von anderen Meßstationen und ist für jede Meßstation individuell unterschiedlich.

Das bisher insbesondere bei Sondervertragskunden im jeweiligen Zähler auch hardware-mäßig enthaltene Tarif-Modul ist aus den Meßstationen 4 ausgelagert und für jede Meßstation individuell als virtuelles, d.h. softwaremäßiges Tarif-Modul auf dem zugehörigen Server 7 vorhanden.

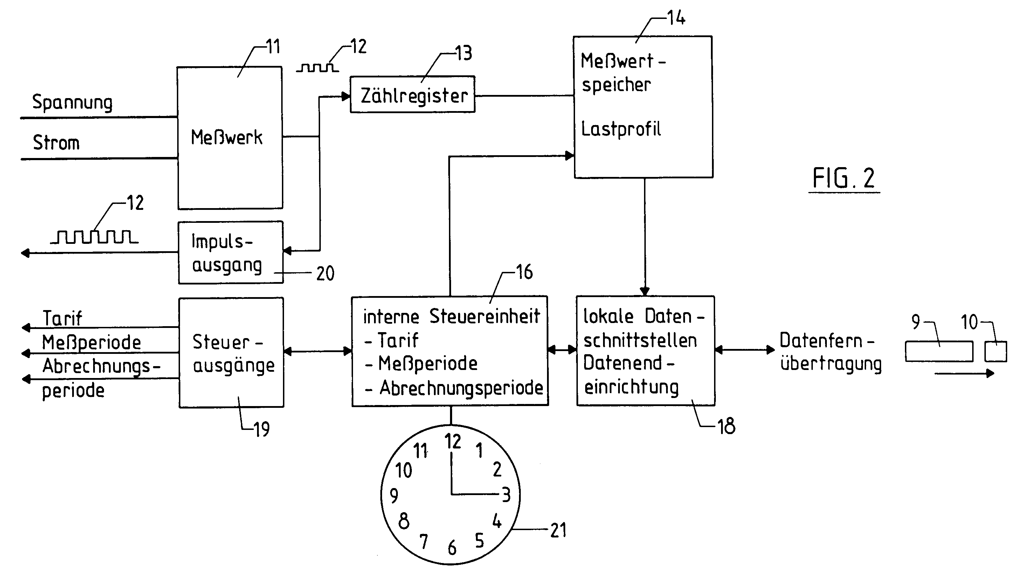

Wie die Fig. 2 zeigt, besitzt jede Meßstation 4 ein Meßwerk 11, welches aus der Spannung und dem Strom unter Berücksichtigung der Phasenlage an seinem Ausgang ein dem Verbrauch proportionales Signal liefert, und zwar bei der dargestellten Ausführungsform in Form einer Impulsfolge 12, wobei jeder Impuls einer bestimmten Energiemenge entspricht (beispielsweise 1000 Impulse/kWh oder auch 1000 Impulse/kVArh).

Die Impulse 12 von einem Zählregister erfaßt, welches an seinem Ausgang einen der Anzahl der eingegangenen Impulse entsprechenden Zählwert liefert, der dann ein Maß für die jeweils verbrauchte Energie ist.

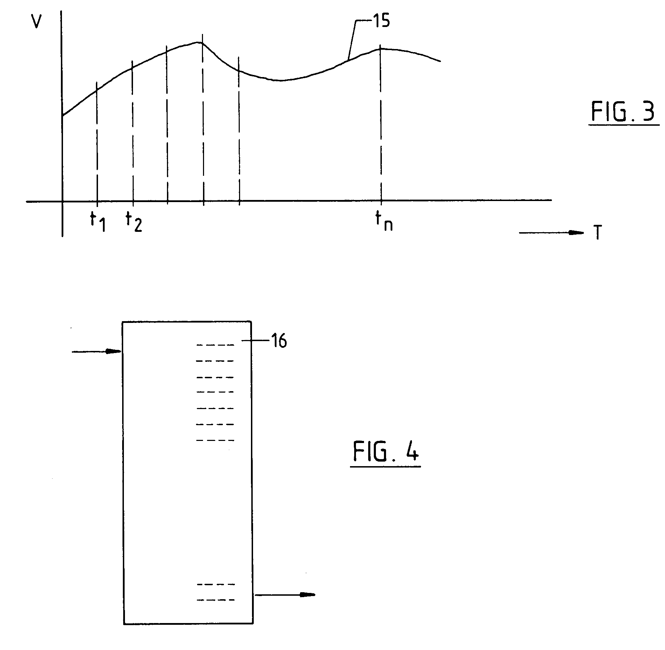

Die von dem Zählregister 13 gelieferten Verbrauchsdaten werden in dem Meßwertspeicher 14 zusammen mit einem Lastprofil, d.h. zusammen mit dem zeitlichen Verlauf des Verbrauchs für eine bestimmte Abfragperiode, beispielsweise Kalendermonat gespeichert. Zum besseren Verständnis wird hierzu auf die Figuren 3 und 4 verwiesen. In der Fig. 3 ist mit dem Graphen 15 ein Lastprofil dargestellt, d.h. die zeitliche Veränderung des Verbrauches. Dieser sich zeitlich ändernde Verbrauch wird jeweils mit einer von der internen Steuereinheit 15 gebildeten Tastfrequenz abgetastet, und zwar zu den Zeiten t1, t2, .... tn, wobei der zu jedem Zeitpunkt seit dem Anfang der Abfragperiode angefallene Verbrauch in einem Speicher 16 des Meßwertspeichers 14 gespeichert wird.

Am Ende jeder Abfragperiode werden dann das Lastprofil 15 sowie der Gesamtverbrauch als Datensatz 9 über die lokale Schnittstelle 18 und das Datennetz 1 an den zugeordneten Server 7 übermittelt.

Das System ist interaktiv ausgebildet, d.h. es besteht die Möglichkeit für einen Berechtigten, z.B. das EVU z.B. von dem Terminal 8 aus an die Meßstationen Daten zu übertragen, und zwar individuell über die jeweilige lokale Schnittstelle 18. Es können beispielsweise die Daten aus dem Meßwertspeicher 14 auch als Datensatz 9 mit der Identifikation 10 vom Terminal 8 oder von dem zugehörigen Server 7 abgerufen werden. Weiterhin können insbesondere auch andere Daten, beispielsweise der Beginn und das Ende von bestimmten Tarifzeiten (Hoch- und Niedrigtarif), Beginn und ggf. Ende der Überwachungsperiode für den Energieverbrauch, Beginn und Ende der Abfrag- bzw. Abrechnungsperiode übertragen werden. Diese Daten werden dann an einem speziellen Steuerausgang 19 zur Verfügung gestellt, an den der jeweilige Kunde ein seinen Energieverbrauch überwachendes und/oder optimierendes Gerät anschließen kann, welchem zusätzlich auch über einen Impulsausgang 20 die verbrauchsabhängigen Impulse 12 zugeführt werden.

Der internen Steuereinheit 16 ist noch eine Echtzeit-Uhr 21 zugeordnet, die beispielsweise mit dem DCF-77 zeitnormal synchronisiert ist.

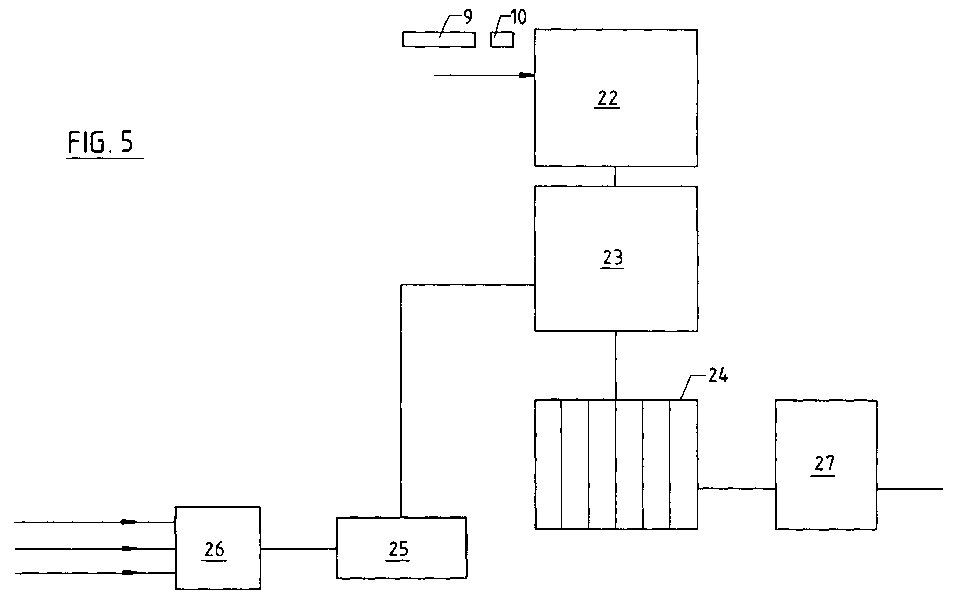

Die Meßdaten der einzelnen Meßstationen 4 werden zyklisch oder aber auf jeweilige Anforderung zu dem jeweiligen Server 7 übertragen. Wie bereits erwähnt, ist jeder Meßeinrichtung 4 auf dem betreffenden Server 7 ein virtuelles Tarif-Modul zugeordnet. Die Erfassung und Berechnung der abrechnungsrelevanten Werte erfolgt auf dem Server 7 in dem jeweiligen Tarif-Modul. Hierfür sind dort softwaremäßig u.a. die in der Fig. 5 wiedergegebenen Funktionen realisiert.

Die zyklisch abgefragten und/oder angeforderten Daten 9 werden zunächst bei 22 zwischengespeichert und dann einer Datenverarbeitung 23 zugeführt, und zwar zur Bildung der abrechnungsrelevanten Werte, die schließlich bei 24 abgespeichert werden.

Bei der Bildung der abrechnungsrelevanten Werte werden die mit dem jeweiligen Kunden vereinbarten und bei 25 abgespeicherten Tarifparameter berücksichtigt. Diese Tarifparameter sind u.a.:

- Tarif- oder Zeit-Zonen bzw. deren Beginn und Ende, insbesondere auch Zeiten für Haupt- und Nebentarife;
- Preis für Haupt- und Nebentarife;
- verbrauchsabhängige Staffelung des Energiepreises;
- maximal zulässiger oder vereinbarter Leistungsshöchstwert;
- maximal in einer Prüfperiode zulässiger Energie-Verbrauch;
- Anfang und Beginn einer jeden Abrechnungsperiode;
- vereinbarter maximaler Energie-Verbrauch während einer Prüfperiode,
- Dauer der Prüfperiode,
- Jahreszeit oder von der Jahreszeit abhängiger Tarif;
- Primärenergie-Kosten bzw. von den Primärenergie-Kosten abhängiger Tarif;
- Beginn und Ende der Bereitstellung von elektrischer Energie (bei einem von mehreren EVUs belieflerten Kunden usw.).

Aus diesen sowie eventuell aus weiteren Tarif-Parametern werden dann durch die Datenverarbeitung 23 die verrechnungsrelevanten Meßgrößen ermittelt und bei 24 abgespeichert.

So sind beispielsweise in dem jeweiligen virtuellen Tarifmodul auch eine oder mehrere der folgende Listen für jeden Verbraucher individuell gespeichert:

| Anzeigeliste Überverbrauch: | | | | | | | | | |
|---|---|---|---|---|---|---|---|---|---|
| Kennzahl | | Format | | | | | | | Interpretation |
| 0 | 0 | 0 | 0 | 0 | 0 | 0 | 0 | 0 | Anzeigekontrolle |
| . | . | . | . | . | . | . | . | . | |
| . | . | . | . | . | . | . | . | . | |
| . | . | . | . | . | . | . | . | . | |
| . | . | . | . | . | . | . | . | . | |
| 9 | 9 | 9 | 9 | 9 | 9 | 9 | 9 | 9 | |
| 0 | 1 | | X | X | X | X | X | X | Identifikationsnummer 01 |

(fortgesetzt)

| Anzeigeliste Überverbrauch: | | | | | | | | | |
|---|---|---|---|---|---|---|---|---|---|
| Kennzahl | | Format | | | | | | | Interpretation |
| 0 | 2 | | X | X | X | X | X | X | Identifikationsnummer 02 |
| | 1 | | | | | X | X | X | Registriergrenze (kWh) |
| | 2 | | | | | X | X | X | Momentanleistung (kWh) |
| | 3 | X | X | X | X | X | X | X | Überverbrauch (kWh) |
| | 4 | X | X | X | X | X | X | X | Hochtarif-Energie (kWh) |
| | 5 | X | X | X | X | X | X | X | Niedertarif-Energie (kWh) |
| | 6 | X | X | X | X | X | X | X | Gesamtverbrauch (kWh) |
| X Dezimalziffer; Kommastelle parametrierbar | | | | | | | | | |

| Ausgabeliste Überverbrauch: | | | | | | | | | |
|---|---|---|---|---|---|---|---|---|---|
| Datensatz | | | | Inhalt | | | | | Interpretation |
| FF(0) | | | | | | 0 | | | fataler Fehler |
| FF01(0) | | | | | | 0 | | | ROM-Fehler |
| FF02(0) | | | | | | 0 | | | RAM-Fehler |
| FF03(0) | | | | | | 0 | | | EEPROM-Fehler |
| FF04(0) | | | | | | 0 | | | Parameter-Fehler |
| FF05(0000) | | | 0 | 0 | 0 | 0 | | | Watchdog-Zähler |
| FF06(0000) | | | 0 | 0 | 0 | 0 | | | Netzausfall-Zähler |
| 01(123456) | 1 | 2 | 3 | 4 | 5 | 6 | | | Identifikationsnr. 01 |
| 02(654321) | 6 | 5 | 4 | 3 | 2 | 1 | | | Identifikationsnr. 02 |
| 1(04.5) | | | | | 0 | 4. | 5 | kW | Registriergrenze |
| 2(01.6) | | | | | 0 | 1. | 6 | kW | Momentanleistung |
| 3(01234.25) | 0 | 1 | 2 | 3 | 4. | 2 | 5 | kWh | Überverbrauch |
| 4(42345.21) | 4 | 2 | 3 | 4 | 5. | 2 | 1 | kWh | Hochtarif-Energie |
| 5(19364.45) | 1 | 9 | 3 | 6 | 4. | 4 | 5 | kWh | Niedertarif-Energie |
| 6(86725.36) | 8 | 6 | 7 | 2 | 5. | 3 | 6 | kWh | Gesamtverbrauch |
| FF Funktionsfehler; (0) kein Fehler; (F) Fehler | | | | | | | | | |

| Anzeigeliste Mehrtarif | | | | | | | | | | | |
|---|---|---|---|---|---|---|---|---|---|---|---|
| Kennzahl | | | | Format | | | | | | | Interpretation |
| 0 | 0 | | | 0 | 0 | 0 | 0 | 0 | 0 | 0 | Anzeigenkontrolle |
| . | | | | . | . | . | . | . | . | . | |
| . | | | | . | . | . | . | . | . | . | |
| . | | | | . | . | . | . | . | . | . | |
| 9 | 9 | | | 9 | 9 | 9 | 9 | 9 | 9 | 9 | |
| 0 | 0 | | | X | X | X | X | X | X | X | Identifikationsnummer |
| 0 | 1 | | | X | X | X | X | X | X | X | aktueller Energietarif 1 |
| 0 | 2 | | | X | X | X | X | X | X | X | aktueller Energietarif 2 |
| 0 | 3 | | | X | X | X | X | X | X | X | aktueller Energietarif 3 |
| 0 | 4 | | | X | X | X | X | X | X | X | aktueller Energietarif 4 |
| 0 | 5 | | | X | X | X | X | X | X | X | Gesamtverbrauch Energie total (kWh) |
| 1 | 0 | | | | | | | | X | X | Anzahl der Abspeicherungen |
| 0 | 1. | 0 | 1 | X | X | X | X | X | X | X | jüngster Vorwert Tarif 1 (kWh) |
| 0 | 2. | 0 | 1 | X | X | X | X | X | X | X | jüngster Vorwert Tarif 2 (kWh) |
| 0 | 3. | 0 | 1 | X | X | X | X | X | X | X | jüngster Vorwert Tarif 3 (kWh) |
| 0 | 4. | 0 | 1 | X | X | X | X | X | X | X | jüngster Vorwert Tarif 4 (kWh) |
| | | | | | | | | | | | |
| 0 | 1. | 1 | 3 | X | X | X | X | X | X | X | ältester Vorwert Tarif 1 (kWh) |
| 0 | 2. | 1 | 3 | X | X | X | X | X | X | X | ältester Vorwert Tarif 2 (kWh) |
| 0 | 3. | 1 | 3 | X | X | X | X | X | X | X | ältester Vorwert Tarif 3 (kWh) |
| 0 | 4. | 1 | 3 | X | X | X | X | X | X | X | ältester Vorwert Tarif 4 (kWh) |
| 1 | 1. | 0 | 1 | X | X | X | X | X | X | X | Benutzungs-h-Zähler Tarif 1 |
| 1 | 1. | 0 | 2 | X | X | X | X | X | X | X | Benutzungs-h-Zähler Tarif 2 |
| 1 | 1. | 0 | 3 | X | X | X | X | X | X | X | Benutzungs-h-Zähler Tarif 3 |
| 1 | 1. | 0 | 4 | X | X | X | X | X | X | X | Benutzungs-h-Zähler Tarif 4 |
| 9 | 8 | | | . | . | . | . | . | . | . | Anzeigeposition für Vorwertspeicherlöschung |
| X Dezimalziffer; Kommastelle parametrierbar | | | | | | | | | | | |

| Ausgabeliste Mehrtarif: | | |
|---|---|---|
| Datensatz | Inhalt | Interpretation |
| FF(00) | 00 | Fehlermeldung codiert |
| 0(6793478) | 6793478 | Identifikationsnummer |
| 8.0(693498.1*kWh) | 693498.1 kWh | Gesamtverbrauch, Energie total |

(fortgesetzt)

| Ausgabeliste Mehrtarif: | | |
|---|---|---|
| Datensatz | Inhalt | Interpretation |
| 8.1.1(347356.4*kWh) | 347356.4 kWh | jüngster Vorwert Tarif 1 |
| 8.2.1(186223.9*kWh) | 186223.9 kWh | jüngster Vorwert Tarif 2 |
| 8.3.1(112738.6*kWh) | 112738.6 kWh | jüngster Vorwert Tarif 3 |
| 8.4.1(047179.2*kWh) | 047179.2 kWh | jüngster Vorwert Tarif 4 |
| . | . | . |
| . | . | . |
| . | . | . |
| . | . | . |
| . | . | . |
| 8.1.13(286923.4*kWh) | 286923.4 kWh | ältester Vorwert Tarif 1 |
| 8.2.13(123459.2*kWh) | 123459.2 kWh | ältester Vorwert Tarif 2 |
| 8.3.13(084327.7*kWh) | 824327.7 kWh | ältester Vorwert Tarif 3 |
| 8.4.14(024286.4*kWh) | 824286.4 kWh | ältester Vorwert Tarif 4 |
| 9.00(37) | 37 | Anzahl der Abspeicherungen |
| 9.01(18) | 18 | Tage zwischen letzter Abspeicherung und Vorwert 1 |
| 9.02(09) | 09 | Tage zwischen letzter Abspeicherung und Vorwert 2 |
| . | . | . |
| 9.12(15) | 13 | Tage zwischen letzter Abspeicherung und Vorwert 12 |
| 9.13(26) | 26 | Tage zwischen letzter Abspeicherung und Vorwert 13 |
| 11.1(012499.5*h) | 012499.5 h | Benutzungs-h-Zähler Tarif 1 |
| 11.2(0187.46.0*h) | 018746.0 h | Benutzungs-h-Zähler Tarif 2 |
| 11.3(024906.2*h) | 024906.2 h | Benutzungs-h-Zähler Tarif 3 |
| 11.4(018746.5*h) | 018746.5 h | Benutzungs-h-Zähler Tarif 4 |

Über eine Eingabe 26, die entweder lokal über eine entsprechende Hardware (Tastatur) oder aber über das Datennetz 1 erfolgt, können die bei 25 gespeicherten Tarif-Parameter für jedes virtuelle Tarif-Modul individuell von Berechtigten eingegeben oder geändert werden, womit eine schnelle Einrichtung und/oder Änderung des jeweiligen virtuellen Tarif-Moduls möglich ist, und zwar insbesondere auch bei Änderung und/oder Anpassung eines Tarifvertrages an neue wirtschaftliche Gegebenheit oder durch den Wettbewerb bedingte Umstände.

Da das jeweilige Tarif-Modul nicht mehr im Zähler beim Kunden integriert ist, sondern virtuell auf dem jeweiligen Netzserver 7 eingerichtet ist, können somit Tarif-Module sehr unterschiedlich und kundenspezifisch problemlos eingerichtet werden. Insbesondere ist aber auch eine Tarifänderung problemlos möglich und erfordert keinen Austausch eines Zählers beim jeweiligen Kunden. Tarif- und Vertragsänderungen können somit kostengünstig durchgeführt werden.

Die jeweilige Meßstation 4 kann mit einer relativ einfachen Konstruktion realisiert werden, womit es möglich ist, die Meßstation 4 bei sämtlichen Kunden eines EVU im wesentlichen einheitlich auszubilden, und zwar unabhängig von der Kundengruppe, d.h. von „normalen" Tarifkunden, Sondervertragskunden, usw.. Es entfallen insbesondere auch die bis jetzt bei Sondervertragskunden notwendigen speziellen Zähler.

Die Vereinfachung und Vereinheitlichung der Meßstationen 4 führt zu Einsparungen von Materialresourcen, zu größeren Stückzahlen bei der Herstellung, zu einer vereinfachten Handhabung bei der Montage, zu einem geringeren Entsorgungsaufwand und zu flexiblen Anpassungsmöglichkeiten an Änderungen im Tarif- und Vertragswesen.

Ein weiterer wesentlicher Vorteil besteht u.a. auch darin, daß an den Meßstationen verschleißabhängige Komponenten, z.B. elektronische oder mechanische Anzeigen, Bedienungselemente usw. entfallen. Hierdurch ergibt sich eine wesentlich erhöhte Lebensdauer der Geräte.

Die im Speicher 24 gespeicherten Daten können von dem jeweiligen Leistungsempfänger über seinen PC-Terminal 6 oder über ein TV-Gerät 5 abgerufen werden, wobei diese Daten über ein Graphikprogramm 27 so aufbereitet werden, daß der jeweilige Kunde nicht nur die verrechnungsrelevanten Werte jederzeit abrufen kann, sondern ihm diese Werte am Bildschirm des TV-Gerätes oder PC-Terminals 6 auch optisch in einer von ihm gewünschten und/oder ihm geläufigen optischen Form angeboten werden.

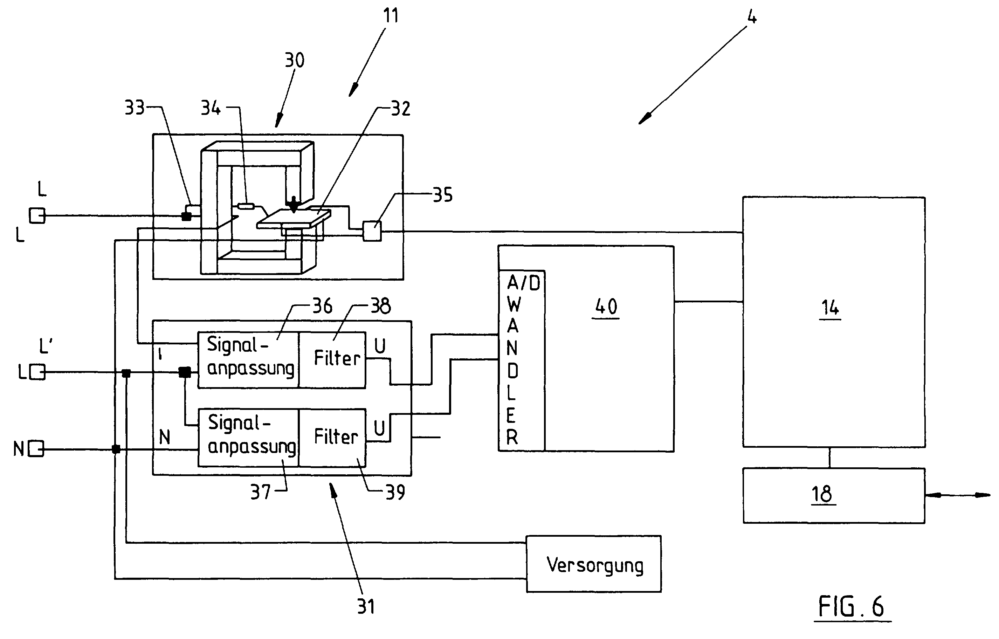

Als Meßwerk 11 eignen sich insbesondere auch solche, die eine hohe Redundanz sicherstellen und zwei unabhängige Meßsysteme aufweisen, welche vorzugsweise nach unterschiedlichen Meßprinzipien arbeiten. Ein derartiges Meßwerk ist in der Fig. 6 dargestellt. Im Detail sind solche Meßwerke in der DE 195 26 870 C1 beschrieben.

Das Meßwerk 11 besteht aus den beiden Meßmodulen 30 und 31, die den gleichen Verbrauch erfassen, und zwar durch unterschiedliche Meßverfahren. Das Meßmodul 30 beruht dabei beispielsweise auf einem Meßverfahren unter Verwendung eines Hallsensors 32. Durch eine Stromspule 33 mit zugehörigem Kern wird ein vom Strom abhängiges, dem Hallsensor 32 durchsetzendes Magnetfeld erzeugt. Über einen Vorwiderstand 34 sind zwei Elektroden des Hallsensors 32 mit der anliegenden Netzspannung beaufschlagt. Die an den beiden anderen Elektroden des Hallsensors anliegende Hallspannung $U_{Hall}$ ist dann proportional zu dem Produkt der Meßgrößen Strom x Spannung x cos $\varphi$.

Dem Hallsensor 32 ist ein Spannungs-Frequenz-Wandler 35 nachgeschaltet, der aus der Hallspannung die Impulsfolge 12 bildet, deren Impulsfolge frequenzabhängig von der Hallspannung und damit abhängig von dem Produkt aus Strom, Spannung und cos $\varphi$ ist. Dieses dem Meßwertspeicher 14 zugeführte Meßsignal 12 hat die Wertigkeit „Impulse/kWh".

Das Meßmodul 31 arbeitet nach einem digitalen Meßverfahren. Die Meßgrößen Strom, Spannung und Phasenwinkel werden in Eingangsstufen 36 und 37 angepaßt und über Tiefpaßfilter 38 und 39 einem in einem Mikroprozessor 40 vorgesehenen Analog-Digital-Wandler zugeführt. Die nach dem Analog-Digital-Wandler vorliegenden digitalen Werte werden von dem Mikroprozessor 40 unter Berücksichtigung der Phasenlage multipliziert und dann dem Meßwertspeicher 14 zugeordnet.

Die von den beiden Meßwandlern 30 und 31 ermittelten Meßwerte werden über das Netzwerk 1 an den zugehörigen Server 7 übertragen und dort gespeichert, um durch die redundante Speicherung die Datensicherheit zu erhöhen. Weiterhin werden die von den Meßmodulen 30 und 31 ermittelten Werte in einem geeigneten Verfahren in dem jeweiligen Server 7 verarbeitet, um so insgesamt ein redundantes System mit der Möglichkeit einer Selbstüberwachung und einer zusätzlichen Fehler-Anzeige und/oder Meldung zu schaffen, die dann erfolgt, wenn die von den beiden Meßmodulen 30 und 31 gelieferten Meßwerte über eine vorgegebene Zeitdauer stärker voneinander abweichen, als dies durch einen vorgegebenen Toleranzbereich oder Grenzwert zugelassen ist.

### *Bezugszeichenliste*

| 1 | Netzwerk |
|---|---|
| 2 | Satellit |
| 3 | Empfänger |
| 4 | Meßstation |
| 5 | TV-Gerät |
| 6 | PC-Terminal |
| 7 | Server |
| 8 | EVU-Terminal |
| 9 | Datensatz |
| 10 | Identifikation |
| 11 | Meßwerk |
| 12 | Impulsfolge |
| 13 | Zählregister |
| 14 | Meßwertspeicher |
| 15 | Kurve |
| 16 | interne Steuereinheit |
| 17 | Speicher |
| 18 | Datenschnittstelle |
| 19 | Steuerausgang |
| 20 | Impulsausgang |
| 21 | Echtzeit-Uhr |
| 22 | Zwischenspeicherung |
| 23 | Datenverarbeitung |

| 24 | Datenspeicher |
| 25 | gespeicherte Tarifparameter |
| 26 | Eingabe |
| 27 | Graphikprogramm |
| 30, 31 | Meßmodul |
| 32 | Hallsensor |
| 33 | Stromspule |
| 34 | Vorwiderstand |
| 35 | Wandler |
| 36, 37 | Eingangsstufe |
| 38, 39 | Tiefpaß |
| 40 | Mikroprozessor |

**Patentansprüche**

1. Verfahren zur Erfassung und/oder Berechnung von abrechnungsrelevanten Verbrauchsgrößen der von Leistungsabnehmern an Leistungsverbrauchern bezogenen Leistung, und zwar durch Messung und Registrierung des Verbrauchs unter Berücksichtigung von in einem Tarifvertrag mit dem jeweiligen Leistungsabnehmer vereinbarten Tarif-Parametern, mit einer Vielzahl von Meßstationen (4), von denen jeweils wenigstens eine einem jeden Leistungsverbraucher zugeordnet ist und die jeweils über wenigstens ein Datennetz (1) mit wenigstens einem an das Datennetz angeschlossenen Rechner oder Server (7) korrespondieren, **dadurch gekennzeichnet,** daß die Meßstationen (4) lediglich den Verbrauch ermitteln und als Verbrauchswerte oder als ein dem jeweiligen Verbrauch proportionaler Datensatz (9) an den zugehörigen Rechner oder Server (7) übertragen, daß sämtliche tarifrelevanten Parameter in dem zugehörigen Rechner oder Server (7) abgelegt und dort die verrechnungsrelevanten Daten unter Berücksichtigung der übermittelten Verbrauchswerte und der Tarifparameter gebildet werden.

2. Verfahren nach Anspruch 1, dadurch gekennzeichnet, daß auf dem jeweiligen Rechner oder Server (7) für jeden Verbraucher wenigstens ein virtuelles Tarif-Modul gebildet ist, welches die abrechnungsrelevanten Verbrauchsgrößen enthält.

3. Verfahren nach Anspruch 1 oder 2, dadurch gekennzeichnet, daß auf dem jeweiligen Rechner oder Server (7) für jeden Verbraucher wenigstens ein virtuelles Tarif-Modul gebildet ist, welches enthält

   - Daten über den während der laufenden Abrechnungsperiode angefallenen Verbrauch, vorzugsweise getrennt für unterschiedliche Tarif-Zonen und/oder Tarif-Zeiten,
   - den in Vergleichszeiten, d.h. z.B innerhalb der letzten Monate angefallenen Verbrauch, vorzugsweise wiederum getrennt nach Tarif-Zonen und/oder Tarif-Zeiten, - den innerhalb der laufenden Abrechnungsperiode angefallenen maximalen Verbrauch, den entsprechenden Wert in einem vorausgegangenen Monat,
   - den Verbrauch gestaffelt nach tarifabhängigen Verbrauchsgrenzen.

4. Verfahren nach einem der vorhergehenden Ansprüche, dadurch gekennzeichnet, daß die Verbrauchsdaten von den Meßstationen (4) zyklisch an den jeweiligen Rechner oder Server (7) übermittelt werden.

5. Verfahren nach einem der vorhergehenden Ansprüche, dadurch gekennzeichnet, daß die Verbrauchsdaten von den Meßstationen (4) auf Abruf, beispielsweise durch den zugeordneten Rechner oder Server oder einen ebenfalls an das Netzwerk (1) angeschlossenes Terminal, an den zugehörigen Rechner oder Server (7) übertragen werden.

6. Verfahren nach einem der vorhergehenden Ansprüche, dadurch gekennzeichnet, daß die Verbrauchsdaten als ein Verbrauchsprofil, welches den zeitlichen Verlauf des Verbrauches enthält, für eine Abrechnungs- oder Abfrageperiode von den Meßstationen (4) an den zugehörigen Rechner oder Server (7) übertragen werden.

7. Verfahren nach einem der vorhergehenden Ansprüche, dadurch gekennzeichnet, daß die Verbrauchsdaten als absoluter Verbrauch innerhalb der Abfrage- oder Abrechnungsperiode übertragen werden

8. Verfahren nach einem der vorhergehenden Ansprüche, dadurch gekennzeichnet, daß die Verbrauchsdaten als absoluter Verbrauch innerhalb der Abfrage- oder Abrechnungsperiode sowie zusätzlich auch als Verbrauchsprofil übertragen werden.

**9.** Verfahren nach einem der vorhergehenden Ansprüche, dadurch gekennzeichnet, daß jede Meßstation einen Meßwertspeicher (14) aufweist, zur Speicherung der Verbrauchsdaten zumindest während einer Abfrage- oder Abrechnungsperiode.

**10.** Verfahren nach einem der vorhergehenden Ansprüche, dadurch gekennzeichnet, daß die Leistungskunden von einem Kunden-Terminal (5, 6) über das Datennetz (1) Zugang zu ihrem jeweiligen auf dem Rechner oder Server (7) gebildeten virtuellen Zähler bzw. Tarif-Modul haben, um die dortigen verrechnungsrelevanten Daten oder Werte für Kontrollzwecke abzurufen.

**11.** Verfahren nach einem der vorhergehenden Ansprüche, gekennzeichnet durch seine Ausbildung als interaktives System, welches verrechnungsrelevante Parameter, insbesondere auch Tarif-Parameter an die Meßstationen (4) übertragen kann, wie z.B. Beginn und Ende einer bestimmten Tarif-Zeit, Beginn und Ende einer Meß- oder Prüfperiode, innerhalb der der in dieser Periode aufgelaufene Gesamtverbrauch gemessen wird, Beginn und Ende der Abfrage- bzw. Abrechnungsperiode.

**12.** Verfahren nach einem der vorhergehenden Ansprüche, dadurch gekennzeichnet, daß wenigstens eine Meßstation (4) Steuerausgänge (19, 20) aufweist, an denen ein dem Verbrauch proportionales Signal (12) sowie verrechnungsrelevante, vom jeweiligen Rechner oder Server (7) übermittelte Signale zur Verfügung stehen, und zwar für die Ansteuerung einer beim Leistungsempfänger installierten Überwachungseinheit, z.B. für ein Energie- Management-System.

**13.** Verfahren nach einem der vorhergehenden Ansprüche, dadurch gekennzeichnet, daß jede Meßstation wenigstens ein Meßwerk (11) zur Erfassung des Verbrauchs sowie wenigstens einen Meßwertspeicher zur Speicherung des gemessenen Verbrauchs zumindest während der jeweiligen Abfrage- bzw. Abrechnungsperiode.

**14.** Verfahren nach einem der vorhergehenden Ansprüche, dadurch gekennzeichnet, daß jede Meßstation (4) zwei das Meßwerk bildende Meßmodule (30, 31) aufweist, die den gleichen Verbrauch messen, und zwar vorzugsweise nach unterschiedlichen Meßmethoden.

**15.** Verfahren nach einem der vorhergehenden Ansprüche, dadurch gekennzeichnet, daß die Meßstationen (4) solche zur Messung des Verbrauchs an elektrischer Energie sind.

SATELLIT 2

SATELLITENANTENNE 3

ZÄHLEIN-RICHTUNG 4

1

SERVER 7

TELEVISION 5

PC TERMINAL 6

VERSCHIEDENE ÜBERTRAGUNGSMEDIEN

ÖFFENTLICHE/PRIVATE NETZE

SERVER 7

EVU-TERMINAL 8

FIG. 1

EP 0 878 892 A2

FIG. 2

Spannung — Strom → Meßwerk (11)

Zählregister (13)

Meßwert-speicher / Lastprofil (14)

Impuls-ausgang (20) — 12

Tarif / Meßperiode / Abrechnungs-periode — Steuer-ausgänge (19)

interne Steuereinheit (16)
- Tarif
- Meßperiode
- Abrechnungsperiode

lokale Daten-schnittstellen / Datenend-einrichtung (18)

Datenfern-übertragung (9) (10)

21

EP 0 878 892 A2

EP 0 878 892 A2

FIG. 3

FIG. 4

FIG. 5

FIG. 6